# EUROPEAN PATENT SPECIFICATION

(11) **EP 4 311 045 B1**
(45) Date of publication and mention of the grant of the patent: **16.09.2026**
(21) Application number: 22771781.6
(22) Date of filing: 17.03.2022
(51) Int. Cl.: H01S 5/11, H01S 5/02, H01S 5/042

(54) **PHOTONIC CRYSTAL SEMICONDUCTOR LASER DEVICE AND METHOD FOR MANUFACTURING SAME**
HALBLEITERLASERVORRICHTUNG MIT PHOTONISCHEM KRISTALL UND HERSTELLUNGSVERFAHREN DAFÜR
DISPOSITIF LASER À SEMI-CONDUCTEUR À CRISTAL PHOTONIQUE ET SON PROCÉDÉ DE FABRICATION

(30) Priority: 17.03.2021 KR 20210034614
(43) Date of publication of application: 24.01.2024
(73) Proprietor: Seoul National University R & DB Foundation, Seoul 08826 (KR)
(72) Inventor: JEON, Heonsu, Seoul 08826 (KR); KIM, Myeong Eun, Seoul 08826 (KR)
(74) Representative: Kuhnen & Wacker Patent- und Rechtsanwaltsbüro PartG mbB
(86) International application number: PCT/KR2022/003738
(87) International publication number: WO 2022/197115

(56) References cited:
- CN-A- 102 201 648
- JP-A- 2006 135 306
- JP-A- 2006 352 015
- KR-A- 20090 130 256
- KR-A- 20140 130 936
- US-A1- 2011 248 242
- US-A1- 2012 014 400
- US-A1- 2012 155 502
- US-B2- 9 991 403
- WANG YUFEI ET AL: "Lateral cavity photonic crystal surface emitting lasers with ultralow threshold and large power", NOVEL IN-PLANE SEMICONDUCTOR LASERS XI, SPIE, 1000 20TH ST. BELLINGHAM WA 98225-6705 USA, vol. 8277, no. 1, 9 February 2012 (2012-02-09), pages 1 - 8, XP060001533, DOI: 10.1117/12.906609

## Description

### TECHNICAL FIELD

The embodiments of the present invention relate to an active optical device, and more particularly, to a semiconductor laser. In detail, the embodiments of the present invention relate to a laser device for electrically driving a photonic crystal laser.

### BACKGROUND ART

A photonic crystal refers to a structure in which two materials having different refractive index are periodically arranged on a scale of approximate optical wavelengths. Representative features of a photonic crystal include photonic bandgap, strong nonlinearity, and dispersion characteristics, and a photonic crystal laser is one of optical crystal devices using such characteristics.

A photonic crystal laser has a laser structure capable of not only providing various functions such as single mode oscillation or laser emission perpendicular to a substrate but also reducing the sizes of existing semiconductor laser devices.

In the case of a photonic crystal laser using a large difference of refractive index among existing semiconductor lasers, electrical driving is very difficult and restrictive due to structural limitations. In order to produce a photonic crystal laser, micro structures having a very large difference of refractive index are required to be formed as a photonic crystal pattern in a horizontal direction in a device. However, such micro structures make it very difficult to adopt metal electrodes that are essential for electrical driving.

In detail, since a correlation between a photonic crystal pattern and a metal electrode is very high, there is a structural limitation between an optical waveguide structure and the metal electrode. Due to this limitation, laser oscillation characteristics of existing photonic crystal lasers are very poor, and electrically driven photonic crystal lasers are not yet commercially used.

CN 102 201 648 A discloses a low-cost band-edge surface-emitting laser with a photonic crystal structure integrated on a Fabry-Perot (FP) ridge-shaped cavity, designed to enable efficient multi-channel coupling and signal integration in optical systems.

US 9 991 403 B2 discloses an optoelectronic device that uses optically responsive nanoparticles placed on cavity sidewalls to enable non-radiative dipole-dipole energy transfer with an underlying electronic structure, allowing the device to function as a light emitter or energy harvester for applications such as LEDs, solar cells, displays, and photodetectors.

### DISCLOSURE OF THE INVENTION

### TECHNICAL PROBLEM

The present invention, which has been derived to resolve the above problems, is to provide a photonic crystal semiconductor laser device capable of being electrically driven and a method for manufacturing the same.

However, this problem is exemplary, and the scope of the present invention is not limited thereto.

### TECHNICAL SOLUTION

The invention is defined by the independent claims.

### ADVANTAGEOUS EFFECTS

According to an embodiment of the present invention configured as described above, a photonic crystal semiconductor laser device can be electrically and stably driven.

If a photonic crystal semiconductor laser device can be stably driven, the size of a device required for single-mode oscillation can be significantly reduced, and industrial application of a photonic crystal laser can be facilitated.

The scope of the present invention is not limited to the above effects.

### BRIEF DESCRIPTION OF THE DRAWINGS

FIG. 1 is a cross-sectional view of a schematic structure of a photonic crystal semiconductor laser device 100 according to an embodiment of the present invention.
FIG. 2 is a diagram illustrating another embodiment in which the photonic crystal semiconductor laser device 100 of FIG. 1 is inverted.
FIG. 3 is a cross-sectional view of a schematic structure of a guide layer 30 of the photonic crystal semiconductor laser device 100 according to an embodiment of the present invention.
FIG. 4 is a graph G1 obtained by calculating light intensity of the photonic crystal laser device 100 in a vertical direction according to an embodiment of the present invention.
FIG. 5 is a graph G2 obtained by calculating a refractive index of the photonic crystal laser device 100 in a vertical direction according to an embodiment of the present invention.
FIGS. 6A to 6F are diagrams for describing a manufacturing method of the photonic crystal semiconductor laser device 100 according to an embodiment of the present invention.
FIG. 7 is a flowchart illustrating a manufacturing method of the photonic crystal semiconductor laser device 100 according to an embodiment of the present invention.
FIG. 8 is a cross-sectional view of a schematic structure of the photonic crystal semiconductor laser device 200 according to another embodiment of the present invention.
FIG. 9 is a graph obtained by calculating light intensity of the photonic crystal laser device 200 in a vertical direction according to the embodiment illustrated in FIG. 8.
FIG. 10 illustrates a result of simulation of an optical band structure of the photonic crystal laser device 200 according to the embodiment illustrated in FIG. 8.
FIG. 11 illustrates a result of simulation of a field profile of the photonic crystal laser device 200.
FIG. 12 is a flowchart illustrating a manufacturing method of the photonic crystal laser device 200 according to the embodiment illustrated in FIG. 8.

### DETAILED DESCRIPTION

### BEST MODE FOR CARRYING OUT THE INVENTION

An embodiment of the present invention provides a photonic crystal semiconductor laser device including an n-type clad layer formed on a first surface of an n-type first substrate, a guide layer formed on the n-type clad layer and including an active layer, a p-type clad layer formed on the guide layer, a p-type contact layer formed on the p-type clad layer, a p-type electrode layer formed on the p-type contact layer, and an n-type electrode layer contacting at least a portion of the first surface of the n-type first substrate or a second surface opposing the first surface, wherein holes penetrating the p-type contact layer, the p-type clad layer, the guide layer including the active layer, and the n-type clad layer are formed in the p-type contact layer, the p-type clad layer, the guide layer including the active layer, and the n-type clad layer, and the holes form a photonic crystal pattern. A thickness of the p-type clad layer is set so that intensity of an optical field approximates to zero at an upper surface of the p-type clad layer, and a thickness of the n-type clad layer is set so that the intensity of the optical field approximates to zero at a lower surface of the n-type clad layer.

In an embodiment of the present invention, refractive index of the p-type clad layer and the n-type clad layer may be lower than a refractive index of the guide layer.

In an embodiment of the present invention, the holes may form a photonic crystal cavity structure including an artificial defect on a stack plane of the photonic crystal semiconductor laser device.

In an embodiment of the present invention, the holes may form a random structure using a disordered photonic crystal structure on a stack plane of the photonic crystal semiconductor laser device.

In an embodiment of the present invention, the holes may be formed in a central region of the photonic crystal semiconductor laser device, and the n-type electrode layer may be formed in an edge region in which the holes are not formed.

In an embodiment of the present invention, the p-type electrode layer may be formed in contact with a region corresponding to the photonic crystal pattern in the p-type contact layer.

An embodiment of the present invention provides a method for manufacturing a photonic crystal semiconductor laser device, the method including the steps of: sequentially forming and stacking an n-type clad layer, a guide layer including an active layer, a p-type clad layer, and a p-type contact layer on a first surface of an n-type first substrate; forming a photonic crystal pattern by forming holes penetrating the p-type contact layer, the p-type clad layer, the guide layer including the active layer, and the n-type clad layer; forming a first metal layer on the p-type contact layer and a second metal layer on a second substrate; abutting and metal bonding the first metal layer and the second metal layer to each other, to form a p-type electrode layer; and forming an n-type electrode layer on at least a portion of the first substrate in which the holes are not formed.

In an embodiment of the present invention, the step of forming the n-type electrode layer may include the steps of: removing a portion of a thickness of the first substrate after the metal bonding step; and forming the n-type electrode layer on at least a portion of a surface of the first substrate having a partially removed thickness.

An embodiment of the present invention provides a method for manufacturing a photonic crystal semiconductor laser device, the method including the steps of: sequentially forming and stacking an n-type clad layer, a guide layer including an active layer, a p-type clad layer, and a p-type contact layer on a first surface of an n-type first substrate; forming a photonic crystal pattern by forming holes penetrating the p-type contact layer, the p-type clad layer, the guide layer including the active layer, and the n-type clad layer; forming a first metal layer on the p-type contact layer and a second metal layer on a second substrate; abutting and metal bonding the first metal layer and the second metal layer to each other, to form a p-type electrode layer; completely removing the first substrate after the metal bonding step; and forming an n-type electrode layer on at least a portion of a surface of the n-type clad layer exposed after the first substrate is completely removed.

An embodiment of the present invention provides a method for manufacturing a photonic crystal semiconductor laser device, the method including the steps of: sequentially forming and stacking an n-type clad layer, a guide layer including an active layer, a p-type clad layer, and a p-type contact layer on an n-type first substrate; forming a first metal layer on the p-type contact layer and a second metal layer on a second substrate; abutting and metal bonding the first metal layer and the second metal layer to each other, to form a p-type electrode layer; removing the n-type first substrate; forming a photonic crystal pattern by forming holes penetrating the n-type clad layer, the guide layer including the active layer, and the p-type clad layer; and forming an n-type electrode layer on at least a portion of a surface of the n-type clad layer in which the holes are not formed.

Other aspects, features, and advantages of the present disclosure will become apparent from the detailed description and the claims in conjunction with the accompanying drawings.

Embodiments of the present invention may be variously modified and may include various examples. However, particular embodiments are exemplarily illustrated in the drawings and will be described in detail. Effects and features of the embodiments of the present invention, and implementation methods thereof will be clarified through following embodiments described with reference to the accompanying drawings. However, the present invention is not limited to the embodiments described below, but may be implemented in various forms.

Hereinafter, embodiments of the present invention will be described in detail with reference to the accompanying drawings. Like reference numerals refer to like elements throughout, and overlapped descriptions are omitted.

As used herein, the singular forms "a," "an" and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components.

Sizes of elements in the drawings may be exaggerated for convenience of explanation. In other words, since sizes and thicknesses of components in the drawings are arbitrarily illustrated for convenience of explanation, the following embodiments are not limited thereto.

In the following embodiments, when a portion such as a region, layer, or component is referred to as being "on" another portion, it can be directly on the other portion or other regions, layers, or components may be interposed therebetween.

In the following embodiments, when a region, layer, or component is referred to as being connected to each other, the region, layer, or component can be directly connected to each other or can be indirectly connected to each other with other regions, layers, or components interposed therebetween.

In the present invention, a photonic crystal semiconductor laser device may also be referred to as a photonic crystal laser device or a laser device.

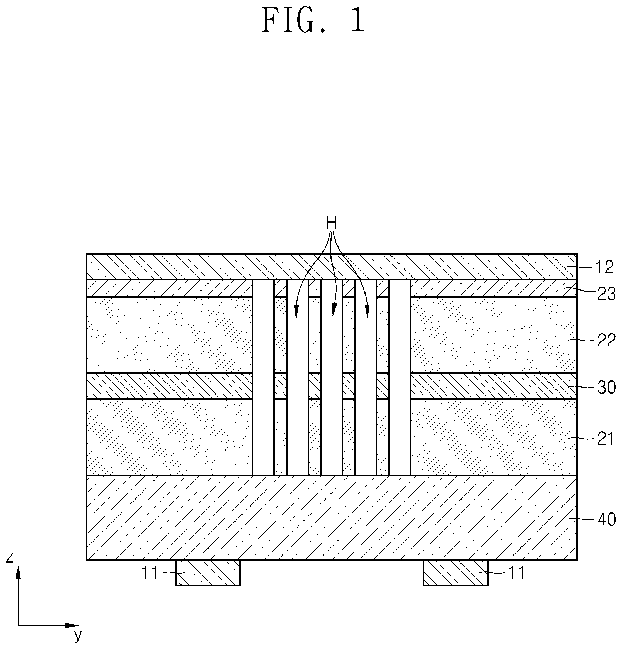

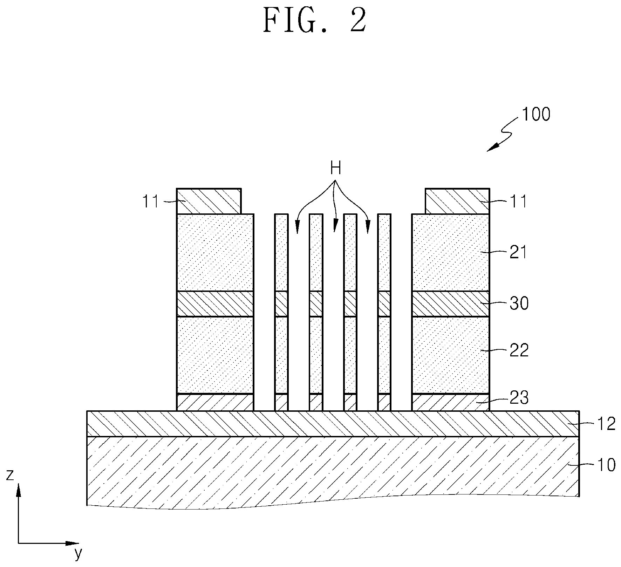

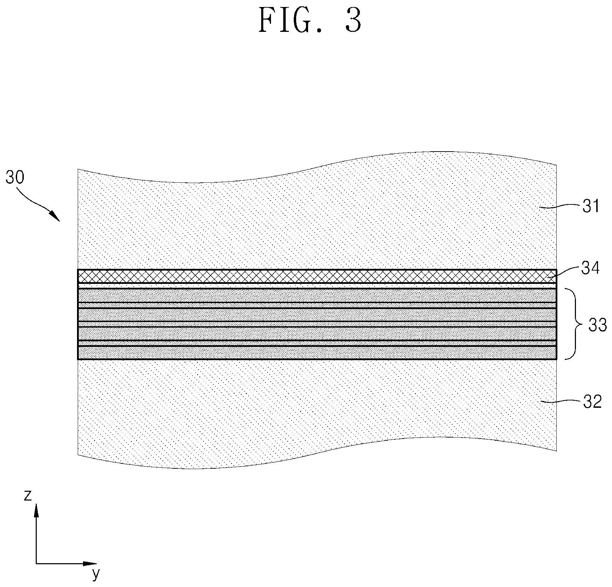

FIG. 1 is a cross-sectional view of a schematic structure of a photonic crystal semiconductor laser device 100 according to an embodiment of the present invention, and FIG. 2 is a diagram illustrating another embodiment in which the photonic crystal semiconductor laser device 100 of FIG. 1 is inverted. FIG. 3 is a cross-sectional view of a schematic structure of a guide layer 30 of the photonic crystal semiconductor laser device 100 according to an embodiment of the present invention.

Hereinafter, a direction (i.e., z direction) in which layers of the photonic crystal semiconductor laser device 100 are stacked will be referred to as a vertical direction. Furthermore, a direction corresponding to a plane (i.e., xy plane) of each layer will be referred to as a horizontal direction. However, these directions are merely examples for describing an embodiment, and the present invention is not limited to the directions.

First, referring to FIG. 1, the photonic crystal laser device 100 according to an embodiment of the present invention includes an n-type clad layer 21 formed on a first surface of an n-type first substrate 40, a guide layer 30 formed on the n-type clad layer 21 and including an active layer 33, a p-type clad layer 22 formed on the guide layer 30, a p-type contact layer 23 formed on the p-type clad layer 22, a p-type electrode layer 12 formed on the p-type contact layer 23, and an n-type electrode layer 11 contacting at least a portion of the first surface of the n-type first substrate 40 or a second surface opposing the first surface. Here, holes H that penetrate the p-type contact layer 23, the p-type clad layer 22, the guide layer 30 including the active layer 33, and the n-type clad layer 21 are formed in the p-type contact layer 23, the p-type clad layer 22, the guide layer 30 including the active layer 33, and the n-type clad layer 21, wherein the holes H form a photonic crystal pattern.

The photonic crystal semiconductor laser devices 100 illustrated in FIGS. 2 and 3 are in a packaged state in which the photonic crystal semiconductor laser device 100 of FIG. 1 is inverted, and include the same components as the photonic crystal semiconductor laser device 100 of FIG. 1 except for the n-type first substrate 40, and thus the same reference numerals are assigned to the same components. The photonic crystal semiconductor laser device 100 of FIG. 1 is the same as the photonic crystal semiconductor laser device 100 of FIG. 2 except that the photonic crystal semiconductor laser device 100 of FIG. 1 is provided with the n-type first substrate 40 in which a hole is not formed, and thus the following descriptions are provided on the basis of the photonic crystal semiconductor laser device 100 of FIG. 2.

Referring to FIGS. 2 and 3, the photonic crystal laser device 100 according to an embodiment of the present invention includes a p-type electrode layer 12 formed on a substrate 10, a contact layer 23 formed on the p-type electrode layer 12, a p-type clad layer 22 formed on the contact layer 23, a guide layer 30 formed on the p-type clad layer 22 and including an active layer 33, an n-type clad layer 21 formed on the guide layer 30, and an n-type electrode layer 11 contacting at least a portion of an upper surface of the n-type clad layer 21. The other portion of the upper surface of the n-type clad layer 21 may contact air.

In the photonic crystal laser device 100 according to an embodiment of the present invention, holes H penetrating the n-type clad layer 21, the guide layer 30 including the active layer 33, the p-type clad layer 22, and the contact layer 23 are formed. The holes H form a two-dimensional photonic crystal pattern on a stack plane (i.e., xy plane). The two-dimensional photonic crystal pattern may be, for example, a hexagonal lattice or honeycomb lattice pattern. However, an embodiment is not limited thereto.

The photonic crystal laser device 100 according to an embodiment of the present invention is capable of electrical oscillation regardless of a shape of the photonic crystal pattern. Therefore, according to an embodiment, the holes H may form a photonic crystal cavity structure including an artificial defect. According to an embodiment, the holes H may also form a random laser structure using a disordered photonic crystal structure. However, an embodiment is not limited thereto.

The penetration holes H forming a two-dimensional photonic crystal pattern are formed in at least a portion of the laser device 100. The n-type electrode layer 11 may be formed on a region in which the penetration holes H are not formed.

According to an embodiment, the penetration holes H may be formed in a central region of the laser device 100. The holes H may not be formed in an edge region of the laser device 100. For example, the n-type electrode layer 11 may be formed on the edge region of the laser device 100.

For example, the n-type electrode layer 11 may be formed surrounding the holes H that form a photonic crystal pattern. For example, the n-type electrode layer 11 may be formed in an annular form when viewed from above an upper surface of the laser device 100. However, this is merely an embodiment, and the region in which the holes H are formed and the shape of the n-type electrode layer 11 are not limited thereto in various embodiments of the present invention.

The n-type electrode layer 11 and the p-type electrode layer 12 include metal. The n-type clad layer 21, the guide layer 30, the p-type clad layer 22, and the contact layer 23 may be composed of a group III-V compound semiconductor material. The contact layer 23, which is a p+ contact layer, may be formed between the p-type electrode layer 12 and the p-type clad layer 22.

The guide layer 30 includes the active layer 33 therein. The active layer 33 may be configured in various forms such as single quantum well or multi-quantum well (MQW).

When a bias is applied through the n-type electrode layer 11 connected to the n-type clad layer 21 and the p-type electrode layer 12 connected to the p-type clad layer 22, electrons and holes having charges are recombined in the active layer 33, thereby generating light. In detail, electrons may move in a direction from the n-type electrode layer 11 to the p-type electrode layer 12. When a voltage is applied between the electrode layers 11 and 12, a p-n junction diode is formed, and light is emitted from the active layer 33.

According to embodiments of the present invention, light emitted from the active layer 33 may meet a photonic crystal structure, thus forming laser. Light electrically emitted from the active layer 33 may form a photonic band structure and optical mode required for laser oscillation, through a two-dimensional crystal pattern formed on an xy plane.

In an embodiment of the present invention, refractive index of the n-type clad layer 21 and p-type clad layer 22 are lower than a refractive index of the guide layer 30. A refractive index difference between the guide layer 30 and the clad layers 21 and 22 may cause formation of a waveguide in the guide layer 30. Accordingly, an optical mode may propagate laterally in the guide layer 30.

Due to the deep holes H forming a two-dimensional photonic crystal pattern, a Bloch mode may be formed in the guide layer 30. That is, in the guide layer 30, an optical mode may be formed according to an optical band structure, and photonic crystal laser may be oscillated through electrical driving.

The contact layer 23, which is a p+ contact layer, is a layer with an increased doping level. The contact layer 23 may facilitate a flow of current between the p-type electrode layer 12 and the p-type clad layer 22 that is a semiconductor material. According to an embodiment, the contact layer 23 may be formed between the p-type electrode layer 12 and the p-type clad layer 22 having low mobility, and a contact layer may be omitted between the n-type electrode 11 and the n-type clad layer 21 having high mobility. However, an embodiment is not limited thereto, and a contact layer may also be formed between the n-type electrode layer 11 and the n-type clad layer 21 in another embodiment of the present invention.

In an embodiment of the present invention, the p-type electrode layer 12 may be arranged in a lower portion of the laser device 100, and the n-type electrode layer 11 may be arranged in an upper portion of the laser device 100.

For example, the p-type electrode layer 12 may be formed in contact with at least a region corresponding to a photonic crystal pattern in the contact layer 23. As an embodiment, the p-type electrode layer 12 may be formed in contact with an entire lower surface of the contact layer 23. The p-type electrode layer 12 may be formed in contact with an upper surface of the substrate 10 and the lower surface of the contact layer 23, and may be formed over an entire stack plane.

The n-type electrode layer 11 may be formed in contact with only a portion of an upper surface of the n-type clad layer 21. For example, the n-type electrode layer 11 may be formed in an edge region of the upper surface of the n-type clad layer 21. In this case, a central region, in which the n-type electrode layer 11 is not formed, of the upper surface of the n-type clad layer 21 may be exposed to air.

As described above, according to an embodiment of the present invention, the n-type electrode layer 11 may be arranged on a peripheral portion of the two-dimensional photonic crystal pattern of the laser device 100. On the contrary, the p-type electrode layer 12 may be formed facing an entire region of the two-dimensional crystal pattern. This is because electrons may spread laterally in the n-type clad layer 21 since a doping level is high and electron mobility is also high in the n-type clad layer 21, but positive holes cannot spread laterally since a doping level is low and positive hole mobility is also low in the p-type clad layer 22.

According to an embodiment of the present invention, since the mobility is lower in a p-type semiconductor than in an n-type semiconductor, the p-type electrode layer 12 may be arranged in a lower portion of the laser device 100 so that the p-type electrode layer 12 may be formed over an entire stack plane. Furthermore, since the mobility is higher in an n-type semiconductor than in a p-type semiconductor, the n-type electrode layer 11 may be arranged in an upper portion of the laser device 100 so that the n-type electrode layer 11 may be formed on an edge of a stack plane.

In an embodiment of the present invention, the p-type electrode layer 12 may be formed over an entire stack plane in a lower portion of the laser device 100 and the n-type electrode layer 11 may be formed in an edge region in an upper portion of the laser device 100 so that performance of the laser device 100 may be improved compared to the opposite case.

The n-type clad layer 21, the guide layer 30, the p-type clad layer 22, and the contact layer 23 may be composed of a group III-V compound semiconductor material.

According to an embodiment, the guide layer 30 may be basically formed of a compound represented by indium gallium arsenide phosphide (InGaAsP). According to an embodiment, the n-type clad layer 21 and the p-type clad layer 22 may be basically formed of a compound represented by indium phosphide (InP), and a corresponding dopant may be added thereto. An n-type dopant may be added to InP to form the n-type clad layer 21, and a p-type dopant may be added to InP to form the p-type clad layer 22. The contact layer 23, which is a p+ contact layer, may be basically formed of a compound represented by indium gallium arsenide (InGaAs) or indium phosphide (InP). However, this is merely an embodiment, and the present invention is not limited thereto. A photonic crystal semiconductor laser device according to various embodiments of the present invention may be composed of various types of compound semiconductor materials.

Referring to FIG. 3, the guide layer 30 includes an n-type guide layer 31 contacting the n-type clad layer 21, a p-type guide layer 32 contacting the p-type clad layer 22, and the active layer 33 between the n-type guide layer 31 and the p-type guide layer 32.

According to an embodiment, the guide layer 30 may be basically formed of a compound represented by indium gallium arsenide phosphide (InGaAsP). For example, the n-type guide layer 31 may be n-doped InGaAsP, and the p-type guide layer 32 may be p-doped InGaAsP. However, this is merely an embodiment, and the present invention is not limited thereto. A photonic crystal semiconductor laser device according to various embodiments of the present invention may be composed of various types of compound semiconductor materials.

According to an embodiment, the active layer 33 may be basically formed of a compound represented by InGaAsP. For example, the active layer 33 may have a structure in which a quantum well of InGaAs and a barrier of InGaAsP are alternately repeated. As an example, FIG.3 illustrates four barrier layers and three quantum well layers therebetween in the active layer 33.

In the n-type guide layer 31, a current spreading layer 34 may be formed at a position close to the active layer 33. In an embodiment, the current spreading layer 34 may be n-doped InGaAsP. For example, a composition ratio of n-InGaAsP constituting the current spreading layer 34 may be different from a composition ratio of n-InGaAsP constituting the n-type guide layer 31.

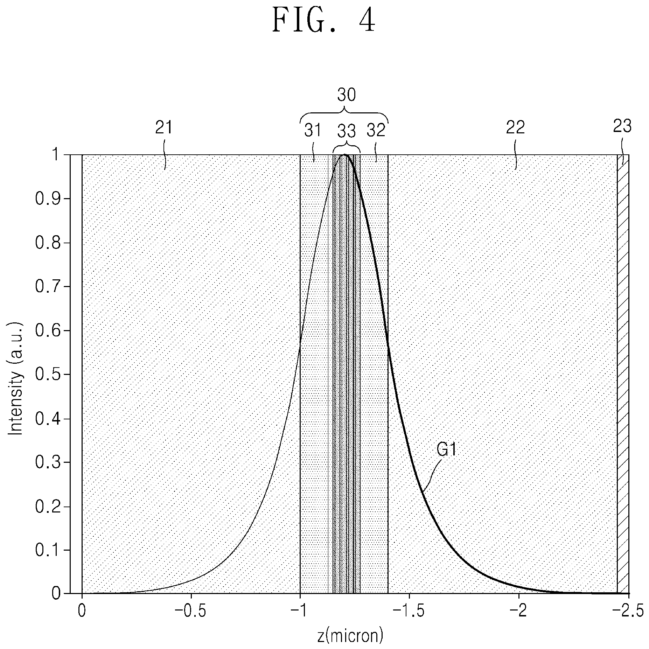

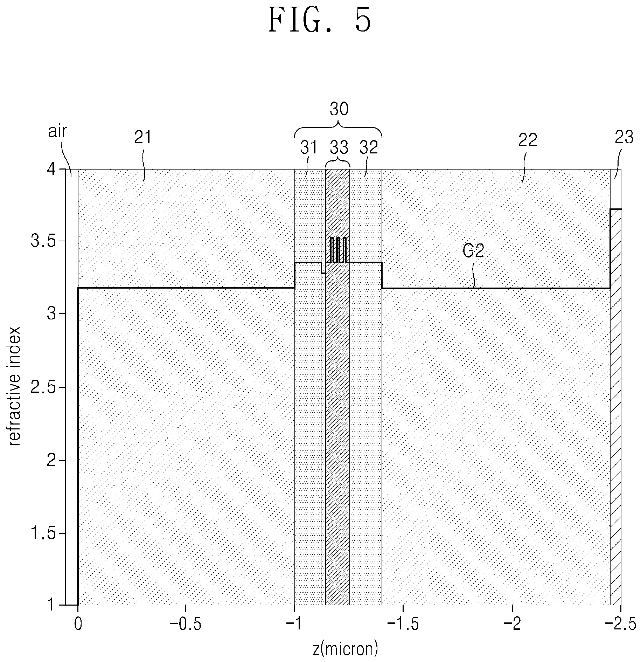

FIG. 4 is a graph G1 obtained by calculating light intensity of the photonic crystal laser device 100 in a vertical direction according to an embodiment of the present invention. FIG. 5 is a graph G2 obtained by calculating a refractive index of the photonic crystal layer device 100 in a vertical direction according to an embodiment of the present invention.

In graphs G1 and G2, it is assumed that the n-type clad layer 21 is n-InP, the n-type guide layer 31 is n-InGaAsP, the p-type guide layer 32 is p-InGaAsP, the p-type clad layer 22 is p-InP, and the contact layer 23 is p +-InP. It is assumed that four i-InGaAsP barrier layers and three i-InGaAs quantum well layers are alternately stacked in the active layer 33. (i represents an undoped state.) Furthermore, it is assumed that the n-type clad layer 21 and the p-type clad layer 22 have a thickness of about 1 µm, and the guide layer 30 has a thickness of about 0.4 µm. However, it is a matter of course that the present invention is not limited thereto.

Referring to graph G2, the refractive index of the guide layer 30 is higher than the refractive index of the clad layers 21 and 22. Due to a refractive index difference between the guide layer 30 and the clad layers 21 and 22, the guide layer 30 may serve as a waveguide. Accordingly, an optical mode may propagate in the guide layer 30.

Graph G1 shows that an optical field is formed around the guide layer 30. Intensity of the optical field is strong in the guide layer 30, and decreases towards an upper portion of the n-type clad layer 21 and towards a lower portion of the p-type clad layer 22. As a result, it is recognized that light intensity approximates to 0 at the upper surface of the n-type clad layer 21 and a lower surface of the p-type clad layer 22. Therefore, according to an embodiment of the present invention, since an optical field does not sense metal of the n-type electrode layer 11 and the p-type electrode layer 12, there may be almost no optical loss, and this is a very import condition for laser oscillation.

If the optical field senses metal, there is no possibility of becoming laser since the optical loss excessively increases. Due to this limitation, the optical loss is excessively large when a metal electrode is directly formed in an existing photonic crystal laser structure by using the guide layer 30 without the clad layers 21 and 22, and thus it is difficult to manufacture a photonic crystal laser capable of electrical injection.

However, according to an embodiment of the present invention, the optical field is unable to sense metal of the n-type electrode layer 11 and the p-type electrode layer 12 since the n-type clad layer 21 and the p-type clad layer 22 having a sufficient thickness are arranged on and under the guide layer 30. For example, the thickness of the n-type clad layer 21 may be set so that the intensity of the optical field approximates to 0 (e.g., equal to or less than specified intensity) at the upper surface of the n-type clad layer 21. The thickness of the p-type clad layer 22 may be set so that the intensity of the optical field approximates to 0 (e.g., equal to or less than specified intensity) at the lower surface of the p-type clad layer 22.

Therefore, according to an embodiment of the present invention, the photonic crystal semiconductor laser device 100 capable of electrical injection regardless of a photonic crystal pattern structure may be provided. Although not illustrated, it was identified that a photonic band structure and a band-edge mode are satisfactorily formed in a structure of the photonic crystal semiconductor laser device 100 according to an embodiment of the present invention.

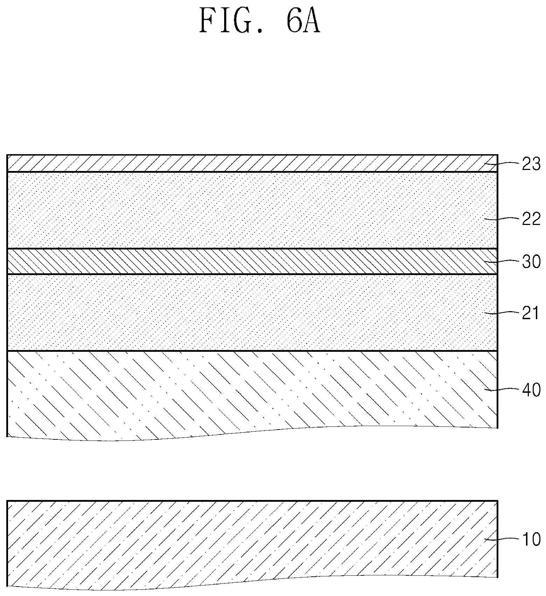

FIGS. 6A to 6F are diagrams for describing a manufacturing method of the photonic crystal semiconductor laser device 100 according to an embodiment of the present invention.

First, two substrates or wafers are prepared in FIG. 6A. A first substrate 40 is a substrate for depositing each layer of a laser device, and a second substrate 10 is a substrate for bonding a manufactured laser device. The n-type clad layer 21, the guide layer 30 including the active layer 33, the p-type clad layer 22, and the contact layer 23, which are described above, are sequentially formed and stacked on the first substrate 40. The first substrate 40 may be, for example, an indium phosphide (InP) substrate. For example, the n-type clad layer 21, the guide layer 30, the p-type clad layer 22, and the contact layer 23 may be deposited in this order on the first substrate 40 through chemical vapor deposition.

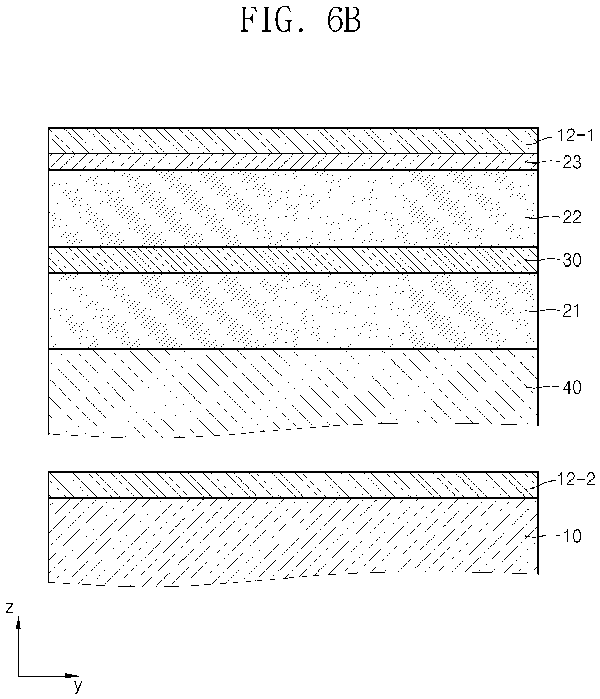

Next, in FIG. 6B, a metal layer 12-1 is formed on the first substrate 40 on which the above-mentioned layers are stacked, and a metal layer 12-2 is formed on the second substrate 10. For example, the metal layers 12-1 and 12-2 may be deposited on the first substrate 40 and the second substrate 10. Therefore, on the first substrate 40, the metal layer 12-1 may be formed on the contact layer 23. Thereafter, the metal layers 12-1 and 12-2 may be metal bonded so as to be used as the p-type electrode layer 12.

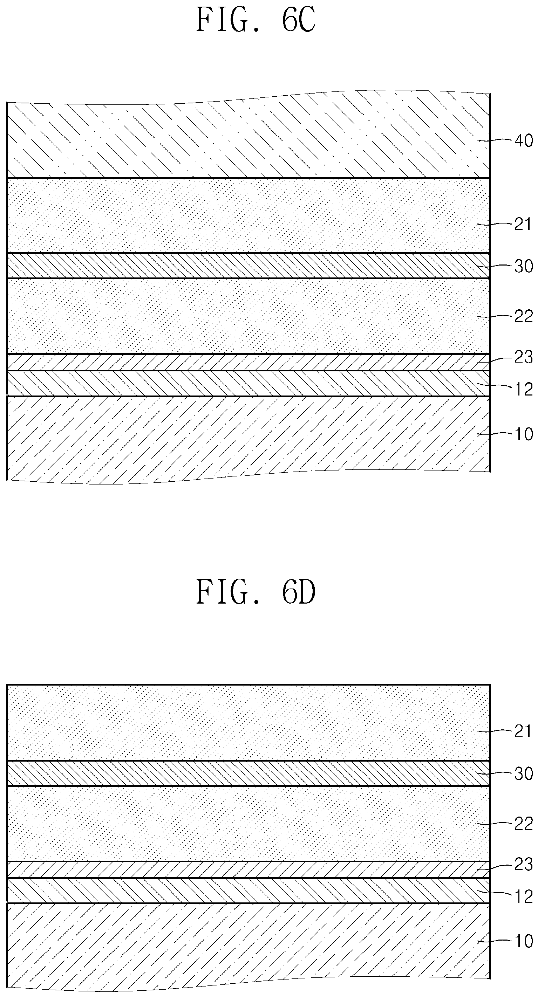

Next, in FIG. 6C, the metal layer 12-1 and the metal layer 12-2 are abutted to each other and metal bonded. The bonded metal layers 12-1 and 12-2 become the p-type electrode layer 12. Since the second substrate 10 and the first substrate 40 are bonded through the medium of the metal layers 12-1 and 12-2, the first substrate 40 may be stably removed, and a laser device may be mounted on the second substrate 10.

As another embodiment, the first substrate 40 is not necessarily removed. The n-type electrode layer 11 described below may also be formed on at least a portion of a surface of the first substrate 40 in which holes are not formed. Here, the thickness of the first substrate 40 may be partially removed.

Next, in FIG. 6D, the first substrate 40 is removed. For example, the first substrate 40 may be removed through wet etching. As a result, the upper surface of the n-type clad layer 21 may be exposed.

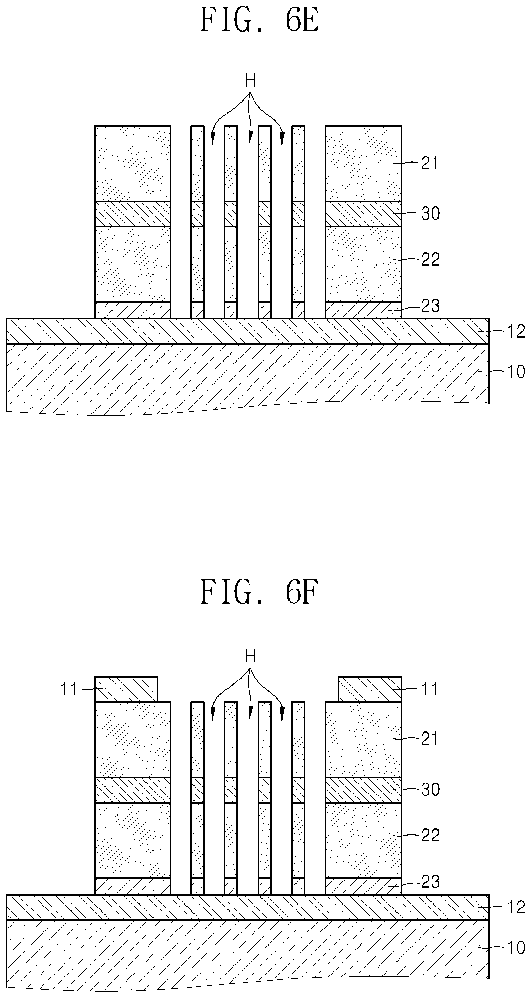

Next, in FIG. 6E, a two-dimensional photonic crystal pattern is formed by forming holes H penetrating the n-type clad layer 21, the guide layer 30, the p-type clad layer 22, and the contact layer 23. For example, a two-dimensional photonic crystal pattern may be inscribed through e-beam lithography, and etching may be performed to a depth of the contact layer 23 on the basis of the inscribed pattern.

Here, although it has been described that the step of forming the holes H penetrating the n-type clad layer 21, the guide layer 30, the p-type clad layer 22, and the contact layer 23 is performed after a metal bonding step, an embodiment is not limited thereto, and the step may be performed before the metal bonding after stacking the n-type clad layer 21, the guide layer 30, the p-type clad layer 22, and the p-type contact layer 23 on the first substrate 40.

Next, in FIG. 6F, the n-type electrode layer 11 is formed on at least a portion of the upper surface of the n-type clad layer 21 in which the holes H are not formed. According to an embodiment, the n-type electrode layer 11 may be deposited through a lift-off method. For example, a pattern for a shape of the n-type electrode layer 11 may be inscribed through e-beam lithography or photolithography, a metal for electrode may be deposited on the inscribed pattern, and the metal may be made to remain only in the pattern through a lift-off method.

As another example, the n-type clad layer 21 may be removed together when the n-type first substrate 40 is removed. In this case, the n-type electrode layer 11 may be formed on at least a portion of an upper surface of the guide layer 30 in which the holes H are not formed.

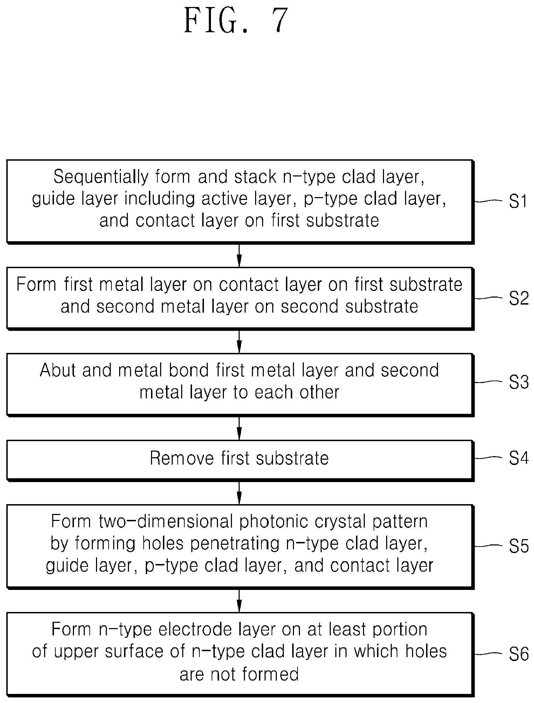

FIG. 7 is a flowchart illustrating a manufacturing method of the photonic crystal semiconductor laser device 100 according to an embodiment of the present invention.

Referring to FIG. 7, in step S1, the n-type clad layer 21, the guide layer 30 including the active layer 33, the p-type clad layer 22, and the contact layer 23 may be sequentially formed and stacked on the first substrate 40. For example, the n-type clad layer 21, the guide layer 30, the p-type clad layer 22, and the contact layer 23 may be sequentially deposited on the first substrate 40. The first substrate 40 is a substrate for depositing each layer.

In step S2, the first metal layer 12-1 may be formed on the contact layer 23 on the first substrate 40, and the second metal layer 12-2 may be formed on the second substrate 10. For example, the metal layers 12-1 and 12-2 may be deposited on the first substrate 40 and the second substrate 10. The second substrate 10 is a substrate for bonding a manufactured laser device.

In step S3, the first metal layer 12-1 and the second metal layer 12-2 may be abutted to each other and metal bonded. The bonded metal layers 12-1 and 12-2 may become the p-type electrode layer 12. Since the second substrate 10 and the first substrate 40 are bonded through the medium of the metal layers 12-1 and 12-2, the first substrate 40 may be stably removed, and a laser device may be mounted on the second substrate 10.

In step S4, the first substrate 40 may be removed. For example, the first substrate 40 may be removed through wet etching. As a result, the upper surface of the n-type clad layer 21 may be exposed.

In step S5, a two-dimensional photonic crystal pattern may be formed by forming holes H penetrating the n-type clad layer 21, the guide layer 30, the p-type clad layer 22, and the contact layer 23. For example, a two-dimensional photonic crystal pattern may be inscribed through e-beam lithography, and etching may be performed to a depth of the contact layer 23 on the basis of the inscribed pattern.

In step S6, the n-type electrode layer 11 may be formed on at least a portion of the upper surface of the n-type clad layer 21 in which the holes H are not formed. According to an embodiment, the n-type electrode layer 11 may be deposited using a lift-off method. For example, a pattern for a shape of the n-type electrode layer 11 may be inscribed through e-beam lithography or photolithography, a metal for electrode may be deposited on the inscribed pattern, and the metal may be made to remain only in the pattern through a lift-off method.

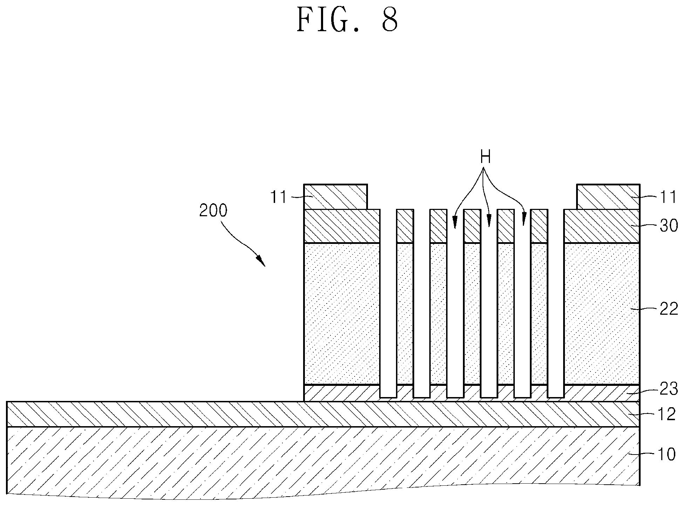

Hereinafter, a photonic crystal semiconductor laser device 200 according to another embodiment of the present invention will be described in detail with reference to FIGS. 8 to 12.

FIG. 8 is a cross-sectional view of a schematic structure of the photonic crystal semiconductor laser device 200 according to another embodiment of the present invention. The photonic crystal laser device 200 according to the other embodiment of the present invention lacks an n-type clad layer compared to the above-mentioned photonic crystal laser device 100.

That is, the photonic crystal laser device 200 includes a p-type electrode layer 12 formed on a substrate 10, a contact layer 23 formed on the p-type electrode layer 12, a p-type clad layer 22 formed on the contact layer 23, a guide layer 30 formed on the p-type clad layer 22 and including an active layer 33, and an n-type electrode layer 11 contacting at least a portion of an upper surface of the guide layer 30. The other portion of the upper surface of the n-type guide layer 30 may contact air.

In the photonic crystal laser device 200, holes H penetrating the guide layer 30, the p-type clad layer 22, and the contact layer 23 are formed. The holes H form a two-dimensional photonic crystal pattern on a stack plane (i.e., xy plane). The holes H may form a two-dimensional photonic crystal pattern, also form a photonic crystal cavity structure including an artificial defect, and also form a random laser structure using a disordered photonic crystal structure.

The photonic crystal laser device 200 only lacks an n-type clad layer compared to the photonic crystal laser device 100 according to the above-mentioned embodiment, and thus overlapping descriptions of the other components will be omitted.

In the photonic crystal laser device 200, a lower surface of the guide layer 30 contacts the p-type clad layer 22, and an upper surface of a region, in which the two-dimensional photonic crystal pattern is formed, of the guide layer 30 contacts air. Here, since the refractive index of the guide layer 30 is higher than the refractive index of the p-type clad layer 22 and air, a waveguide may be formed in the guide layer 30. Accordingly, an optical mode may propagate laterally in the guide layer 30.

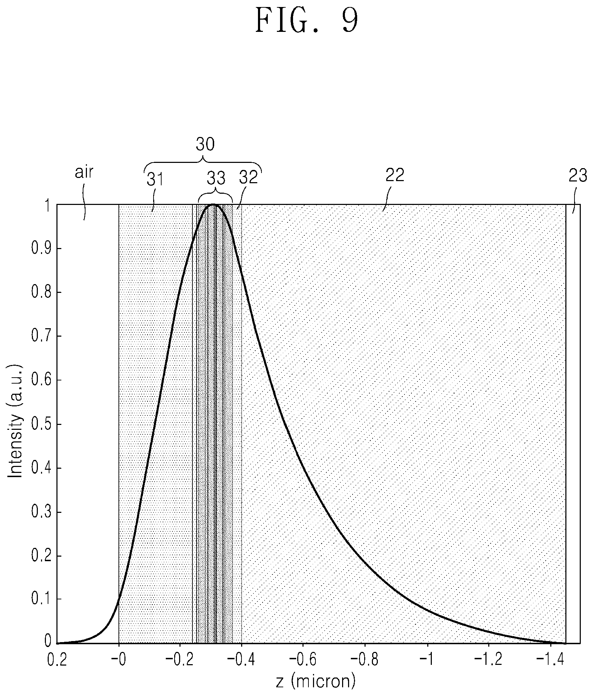

FIG. 9 is a graph obtained by calculating light intensity of the photonic crystal laser device 200 in a vertical direction according to the embodiment illustrated in FIG. 8.

It is recognized that an optical field is asymmetrically formed since the photonic crystal laser device 200 lacks an n-type clad layer and is thus asymmetric in a vertical direction (z direction). Since the refractive index of the p-type clad layer 22 under the guide layer 30 is higher than the refractive index of air above the guide layer 30, the optical field is biased towards a lower portion of the guide layer 30. Since it is desirable to form the active layer 33 in a region in which the optical field is strong, the active layer 33 may be arranged biased towards the p-type clad layer 22 in the guide layer 30 of the photonic crystal laser device 200.

That is, in the guide layer 30 of the photonic crystal laser device 200, the p-type guide layer 32 may be formed thinner than the n-type guide layer 31.

It is recognized that light intensity approximates to 0 at the upper surface of the guide layer 30 and the lower surface of the p-type clad layer 22 in the photonic crystal laser device 200. Therefore, according to an embodiment of the present invention, since an optical field does not sense metal of the n-type electrode layer 11 and the p-type electrode layer 12, there may be almost no optical loss, and this is a very import condition for laser oscillation.

Therefore, according to an embodiment of the present invention, the photonic crystal semiconductor laser device 200 capable of electrical injection regardless of a photonic crystal pattern structure may be provided.

According to embodiments of the present invention, light emitted from the active layer 33 may meet a photonic crystal structure, thus forming laser. Light electrically emitted from the active layer 33 may form a photonic band structure and optical mode required for laser oscillation, through a two-dimensional crystal pattern formed on an xy plane.

It was identified that a photonic band structure and a band-edge mode are satisfactorily formed also in the asymmetric photonic crystal laser device 200 according to an embodiment of the present invention.

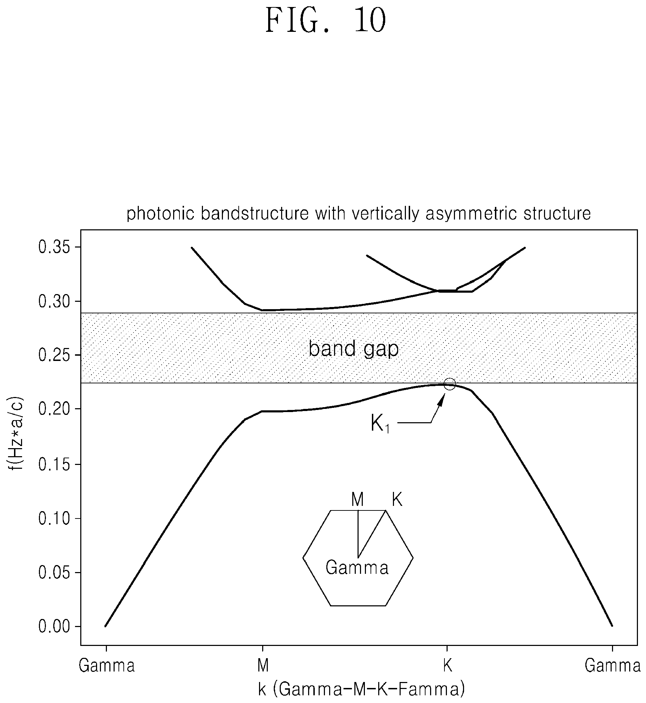

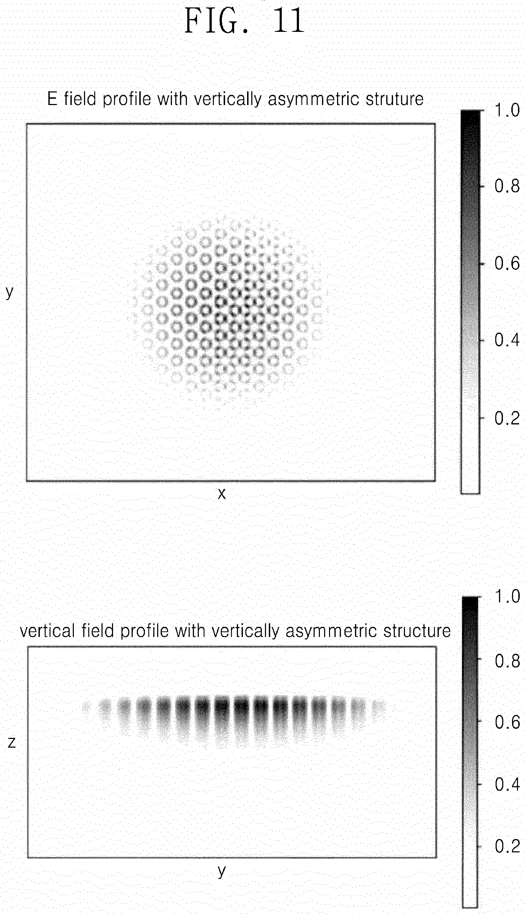

FIG. 10 illustrates a result of simulation of an optical band structure of the photonic crystal laser device 200 according to the embodiment illustrated in FIG. 8, and FIG. 11 illustrates a result of simulation of a field profile of the photonic crystal laser device 200.

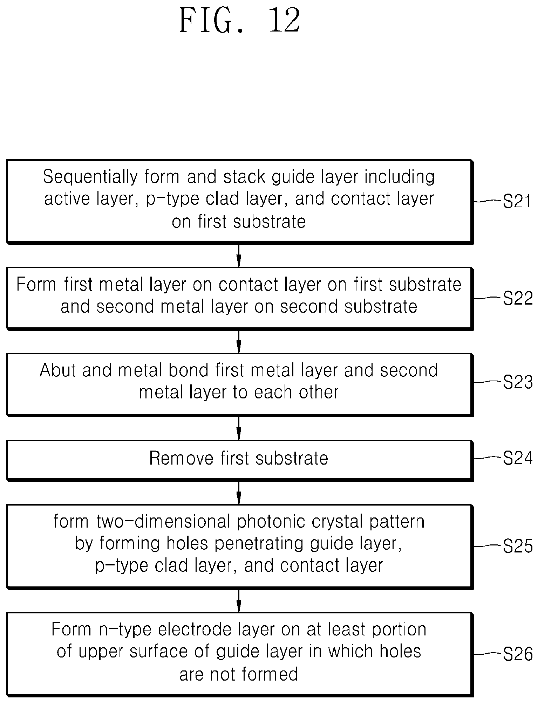

FIG. 12 is a flowchart illustrating a manufacturing method of the photonic crystal laser device 200 according to the embodiment illustrated in FIG. 8.

Referring to FIG. 12, in step S21, the guide layer 30 including the active layer 33, the p-type clad layer 22, and the contact layer 23 may be sequentially formed and stacked on a first substrate. For example, the guide layer 30, the p-type clad layer 22, and the contact layer 23 may be sequentially deposited on the first substrate. The first substrate is a substrate for depositing each layer.

In step S22, a first metal layer may be formed on the contact layer 23 on the first substrate, and a second metal layer may be formed on the second substrate 10. For example, the metal layers may be deposited on the first substrate and the second substrate 10. The second substrate 10 is a substrate for bonding the manufactured laser device 200.

In step S23, the first metal layer and the second metal layer may be abutted to each other and metal bonded. The bonded metal layers may become the p-type electrode layer 12. Since the second substrate 10 and the first substrate are bonded through the medium of the metal layers, the first substrate may be stably removed, and a laser device may be mounted on the second substrate 10.

In step S24, the first substrate may be removed. For example, the first substrate may be removed through wet etching. As a result, the upper surface of the guide layer 30 may be exposed.

In step S25, a two-dimensional photonic crystal pattern may be formed by forming holes H penetrating the guide layer 30, the p-type clad layer 22, and the contact layer 23. For example, a two-dimensional photonic crystal pattern may be inscribed through e-beam lithography, and etching may be performed to a depth of the contact layer 23 on the basis of the inscribed pattern.

In step S26, the n-type electrode layer 11 may be formed on at least a portion of the upper surface of the guide layer 30 in which the holes H are not formed. According to an embodiment, the n-type electrode layer 11 may be deposited using a lift-off method. For example, a pattern for a shape of the n-type electrode layer 11 may be inscribed through e-beam lithography or photolithography, a metal for electrode may be deposited on the inscribed pattern, and the metal may be made to remain only in the pattern through a lift-off method.

The photonic crystal semiconductor laser device 200 described through FIGS. 8 to 12 has an asymmetric guide structure in which an n-type clad layer has been removed. In the case of such an asymmetric guide structure, a manufacturing process is very easy since an etching depth of the holes H may be reduced. Furthermore, it was identified that a photonic band structure is satisfactorily formed also in a structure of the photonic crystal semiconductor laser device 200 having an asymmetric guide structure.

Although the present invention has been described with reference to the embodiments illustrated in the drawings, the embodiments are merely examples and it should be understood that other various modifications and equivalent embodiments could be made by those skilled in the art. Therefore, the technical protection scope of the present invention should be determined based on the technical concept of the following claims.

### INDUSTRIAL APPLICABILITY

According to an embodiment of the present invention, a photonic crystal semiconductor laser device and a method for manufacturing the same are provided.

## Claims

1. A photonic crystal semiconductor laser device (100) comprising:
an n-type clad layer (21) formed on a first surface of an n-type first substrate (40);
a guide layer (30) formed on the n-type clad layer (21) and including an active layer (33);
a p-type clad layer (22) formed on the guide layer (30);
a p-type contact layer (23) formed on the p-type clad layer (22);
a p-type electrode layer (12) formed on the p-type contact layer (23); and
an n-type electrode layer (11) contacting at least a portion of the first surface of the n-type first substrate (40) or a second surface opposing the first surface,
wherein holes (H) penetrating the p-type contact layer (23), the p-type clad layer (22), the guide layer (30) including the active layer (33), and the n-type clad layer (21) are formed in the p-type contact layer (23), the p-type clad layer (22), the guide layer (30) including the active layer (33), and the n-type clad layer (21),
wherein the holes (H) form a photonic crystal pattern,
wherein a thickness of the p-type clad layer (22) is set so that intensity of an optical field approximates to zero at an upper surface of the p-type clad layer (22), and
wherein a thickness of the n-type clad layer (21) is set so that the intensity of the optical field approximates to zero at a lower surface of the n-type clad layer (21).

2. The photonic crystal semiconductor laser device of claim 1, wherein refractive index of the p-type clad layer and the n-type clad layer are lower than a refractive index of the guide layer.

3. The photonic crystal semiconductor laser device (100) of claim 1, wherein the holes (H) form a photonic crystal cavity structure including an artificial defect on a stack plane of the photonic crystal semiconductor laser device (100).

4. The photonic crystal semiconductor laser device (100) of claim 1, wherein the holes (H) form a random structure using a disordered photonic crystal structure on a stack plane of the photonic crystal semiconductor laser device (100).

5. The photonic crystal semiconductor laser device (100) of claim 1, wherein the holes (H) are formed in a central region of the photonic crystal semiconductor laser device (100), and the n-type electrode layer (11) is formed in an edge region in which the holes (H) are not formed.

6. The photonic crystal semiconductor laser device (100) of claim 1, wherein the p-type electrode layer (12) is formed in contact with a region corresponding to the photonic crystal pattern in the p-type contact layer (23).

7. A method for manufacturing a photonic crystal semiconductor laser device (100), the method comprising the steps of:
sequentially forming and stacking an n-type clad layer (21), a guide layer (30) including an active layer (33), a p-type clad layer (22), and a p-type contact layer (23) on a first surface of an n-type first substrate (40);
forming a photonic crystal pattern by forming holes (H) penetrating the p-type contact layer (23), the p-type clad layer, (22), the guide layer (30) including the active layer (33), and the n-type clad layer (21);
forming a first metal layer (12-1) on the p-type contact layer (23) and a second metal layer (12-2) on a second substrate (10);
abutting and metal bonding the first metal layer (12-1) and the second metal layer (12-2) to each other, to form a p-type electrode layer (12); and
forming an n-type electrode layer (11) on at least a portion of the first substrate (40) in which the holes (H) are not formed.

8. The method of claim 7, wherein the step of forming the n-type electrode layer (11) comprises the steps of:
removing a portion of a thickness of the first substrate (40) after the metal bonding step; and
forming the n-type electrode layer (11) on at least a portion of a surface of the first substrate (40) having a partially removed thickness.

9. A method for manufacturing a photonic crystal semiconductor laser device (100), the method comprising the steps of:
sequentially forming and stacking an n-type clad layer (21), a guide layer (30) including an active layer (33), a p-type clad layer (22), and a p-type contact layer (23) on a first surface of an n-type first substrate (40);
forming a photonic crystal pattern by forming holes (H) penetrating the p-type contact layer (23), the p-type clad layer (22), the guide layer (30) including the active layer (33), and the n-type clad layer (21);
forming a first metal layer (12-1) on the p-type contact layer (23) and a second metal layer (12-2) on a second substrate (10);
abutting and metal bonding the first metal layer (12-1) and the second metal layer (12-2) to each other, to form a p-type electrode layer (12);
completely removing the first substrate (40) after the metal bonding step; and
forming an n-type electrode layer (11) on at least a portion of a surface of the n-type clad layer (21) exposed after the first substrate (40) is completely removed.

10. A method for manufacturing a photonic crystal semiconductor laser device (100), the method comprising the steps of:
sequentially (S1) forming and stacking an n-type clad layer (21), a guide layer (30) including an active layer, a p-type clad layer (22), and a p-type contact layer (23) on an n-type first substrate (40);
forming (S2) a first metal layer (12-1) on the p-type contact layer (23) and a second metal layer (12-2) on a second substrate (10);
abutting (S3) and metal bonding the first metal layer (12-1) and the second metal layer (12-2) to each other, to form a p-type electrode layer (12);
removing (S4) the n-type first substrate (40);
forming (S5) a photonic crystal pattern by forming holes (H) penetrating the n-type clad layer (21), the guide layer (30) including the active layer (33), and the p-type clad layer (22); and
forming (S6) an n-type electrode layer (11) on at least a portion of a surface of the n-type clad layer (21) in which the holes (H) are not formed.

## Patentansprüche

1. Photonenkristall-Halbleiterlaservorrichtung (100), umfassend:
eine n-dotierte Mantelschicht (21), die auf einer ersten Oberfläche eines ersten Substrats vom n-Typ (40) ausgebildet ist;
eine Wellenleiterschicht (30), die auf der n-dotierten Mantelschicht (21) ausgebildet ist und eine aktive Schicht (33) umfasst;
eine p-dotierte Mantelschicht (22), die auf der Wellenleiterschicht (30) ausgebildet ist;
eine p-dotierte Kontaktschicht (23), die auf der p-dotierten Mantelschicht (22) ausgebildet ist;
eine p-dotierte Elektrodenschicht (12), die auf der p-dotierten Kontaktschicht (23) ausgebildet ist; und
eine n-dotierte Elektrodenschicht (11), die zumindest einem Teil der ersten Oberfläche des ersten Substrats vom n-Typ (40) oder eine der ersten Oberfläche gegenüberliegende zweite Oberfläche berührt,
wobei in der p-dotierten Kontaktschicht (23), der p-dotierten Mantelschicht (22), der Wellenleiterschicht (30) einschließlich der aktiven Schicht (33) und der n-dotierten Mantelschicht (21) Löcher (H) ausgebildet sind, die die p-dotierte Kontaktschicht (23), die p-dotierte Mantelschicht (22), die Wellenleiterschicht (30) einschließlich der aktiven Schicht (33) und die n-dotierte Mantelschicht (21) durchdringen,
wobei die Löcher (H) ein Photonenkristallmuster ausbilden,
wobei eine Dicke der p-dotierten Mantelschicht (22) so eingestellt ist, dass die Intensität eines optischen Feldes an einer oberen Oberfläche der p-dotierten Mantelschicht (22) sich Null annähert, und
wobei eine Dicke der n-dotierten Mantelschicht (21) so eingestellt ist, dass die Intensität des optischen Feldes an einer unteren Oberfläche der n-dotierten Mantelschicht (21) sich Null annähert.

2. Photonenkristall-Halbleiterlaservorrichtung nach Anspruch 1, wobei der Brechungsindex der p-dotierten Mantelschicht und der n-dotierten Mantelschicht kleiner ist als ein Brechungsindex der Wellenleiterschicht.

3. Photonenkristall-Halbleiterlaservorrichtung (100) nach Anspruch 1, wobei die Löcher (H) eine Photonenkristall-Kavitätsstruktur ausbilden, die einen künstlichen Defekt auf einer Schichtebene der Photonenkristall-Halbleiterlaservorrichtung (100) aufweist.

4. Photonenkristall-Halbleiterlaservorrichtung (100) nach Anspruch 1, wobei die Löcher (H) eine Zufallsstruktur bilden unter Verwendung einer ungeordneten Photonenkristallstruktur auf einer Schichtebene der Photonenkristall-Halbleiterlaservorrichtung (100).

5. Photonenkristall-Halbleiterlaservorrichtung (100) nach Anspruch 1, wobei die Löcher (H) in einem Zentralbereich der Photonenkristall-Halbleiterlaservorrichtung (100) ausgebildet sind, und die n-dotierte Elektrodenschicht (11) in einem Randbereich ausgebildet ist, in dem die Löcher (H) nicht ausgebildet sind.

6. Photonenkristall-Halbleiterlaservorrichtung (100) nach Anspruch 1, wobei die p-dotierte Elektrodenschicht (12) in Kontakt mit einem Bereich ausgebildet ist, der dem Photonenkristallmuster in der p-dotierten Kontaktschicht (23) entspricht.

7. Verfahren zum Herstellen einer Photonenkristall-Halbleiterlaservorrichtung (100), welches folgende Schritte umfasst:
nacheinander Ausbilden und Stapeln einer n-dotierten Mantelschicht (21), einer Wellenleiterschicht (30), die eine aktiven Schicht (33) umfasst, einer p-dotierten Mantelschicht (22) und einer p-dotierten Kontaktschicht (23) auf einer ersten Oberfläche eines ersten Substrats vom n-Typ (40);
Ausbilden eines Photonenkristallmusters durch Ausbilden von Löchern (H), die die p-dotierte Kontaktschicht (23), die p-dotierte Mantelschicht (22), die Wellenleiterschicht (30) einschließlich der aktiven Schicht (33) und die n-dotierte Mantelschicht (21) durchdringen;
Ausbilden einer ersten Metallschicht (12-1) auf der p-dotierten Kontaktschicht (23) und einer zweiten Metallschicht (12-2) auf einem zweiten Substrat (10);
Aneinanderlegen der ersten Metallschicht (12-1) und der zweiten Metallschicht (12-2) und metallisches Bonden miteinander, um eine p-dotierte Elektrodenschicht (12) zu bilden; und
Ausbilden einer n-dotierten Elektrodenschicht (11) auf zumindest einem Teil des ersten Substrats (40), in dem die Löcher (H) nicht ausgebildet sind.

8. Verfahren nach Anspruch 7, wobei der Schritt des Ausbildens der n-dotierten Elektrodenschicht (11) folgende Schritte umfasst:
Entfernen eines Teils einer Dicke des ersten Substrats (40) nach dem Schritt des metallischen Bondens; und
Ausbilden der n-dotierten Elektrodenschicht (11) auf zumindest einem Teil einer Oberfläche des ersten Substrats (40), deren Dicke teilweise entfernt ist.

9. Verfahren zum Herstellen einer Photonenkristall-Halbleiterlaservorrichtung (100), wobei das Verfahren die folgende Schritte umfasst:
nacheinander Ausbilden und Stapeln einer n-dotierten Mantelschicht (21), einer Wellenleiterschicht (30), die eine aktive Schicht (33) enthält, einer p-dotierten Mantelschicht (22) und einer p-dotierten Kontaktschicht (23) auf einer ersten Oberfläche eines ersten Substrats vom n-Typ (40);
Ausbilden eines Photonenkristallmusters durch Ausbilden von Löchern (H), die die p-dotierte Kontaktschicht (23), die p-dotierte Mantelschicht (22), die Wellenleiterschicht (30) einschließlich der aktiven Schicht (33) und die n-dotierte Mantelschicht (21) durchdringen;
Ausbilden einer ersten Metallschicht (12-1) auf der p-dotierten Kontaktschicht (23) und einer zweiten Metallschicht (12-2) auf einem zweiten Substrat (10);
Aneinanderlegen der ersten Metallschicht (12-1) und der zweiten Metallschicht (12-2) und metallisches Bonden miteinander, um eine p-dotierte Elektrodenschicht (12) zu bilden;
vollständiges Entfernen des ersten Substrats (40) nach dem Schritt des metallischen Bondens; und
Ausbilden einer n-dotierten Elektrodenschicht (11) auf zumindest einem Teil einer Oberfläche der n-dotierten Mantelschicht (21), die nach dem vollständigen Entfernen des ersten Substrats (40) freigelegt ist.

10. Verfahren zum Herstellen einer Photonenkristall-Halbleiterlaservorrichtung (100), wobei das Verfahren die folgenden Schritte umfasst:
nacheinander (S1) Ausbilden und Stapeln einer n-dotierten Mantelschicht (21), einer Wellenleiterschicht (30), die eine aktive Schicht enthält, einer p-dotierten Mantelschicht (22) und einer p-dotierten Kontaktschicht (23) auf einem ersten Substrat vom n-Typ (40);
Ausbilden (S2) einer ersten Metallschicht (12-1) auf der p-dotierten Kontaktschicht (23) und einer zweiten Metallschicht (12-2) auf einem zweiten Substrat (10);
Aneinanderlegen (S3) der ersten Metallschicht (12-1) und der zweiten Metallschicht (12-2) und metallisches Bonden miteinander, um eine p-dotierte Elektrodenschicht (12) zu bilden;
Entfernen (S4) des ersten Substrats vom n-Typ (40);
Ausbilden (S5) eines Photonenkristallmusters durch Ausbilden von Löchern (H), die die n-dotierte Mantelschicht (21), die Wellenleiterschicht (30) einschließlich der aktiven Schicht (33) und die p-dotierte Mantelschicht (22) durchdringen; und
Ausbilden (S6) einer n-dotierten Elektrodenschicht (11) auf zumindest einem Teil einer Oberfläche der n-dotierten Mantelschicht (21), in der die Löcher (H) nicht ausgebildet sind.

## Revendications

1. Dispositif de laser semi-conducteur à cristal photonique (100) comprenant :
une couche de confinement de type n (21) formée sur une première surface d'un premier substrat de type n (40) ;
une couche de guidage (30) formée sur ladite couche de confinement de type n (21) et comprenant une couche active (33) ;
une couche de confinement de type p (22) formée sur ladite couche de guidage (30) ;
une couche de contact de type p (23) formée sur ladite couche de confinement de type p (22) ;
une couche d'électrode de type p (12) formée sur ladite couche de contact de type p (23) ; et
une couche d'électrode de type n (11) en contact avec au moins une partie de la première surface du premier substrat de type n (40) ou une deuxième surface opposée à ladite première surface,
dans lequel des trous (H) sont ménagés dans la couche de contact de type p (23), la couche de confinement de type p (22), la couche de guidage (30) comprenant la couche active (33) et la couche de confinement de type n (21), lesdits trous (H) traversant la couche de contact de type p (23), la couche de confinement de type p (22), la couche de guidage (30) comprenant la couche active (33) et la couche de confinement de type n (21),
dans lequel les trous (H) forment un motif de cristal photonique,
dans lequel une épaisseur de la couche de confinement de type p (22) est réglée de sorte que l'intensité d'un champ optique tende vers zéro à la surface supérieure de la couche de confinement de type p (22), et
dans lequel une épaisseur de la couche de confinement de type n (21) est réglée de sorte que l'intensité du champ optique tende vers zéro à la surface inférieure de la couche de confinement de type n (21).

2. Dispositif de laser semi-conducteur à cristal photonique (100) selon la revendication 1, dans lequel les indices de réfraction de la couche de confinement de type p et de la couche de confinement de type n sont inférieurs à l'indice de réfraction de la couche de guidage.

3. Dispositif de laser semi-conducteur à cristal photonique (100) selon la revendication 1, dans lequel les trous (H) forment une structure de cavité de cristal photonique comprenant un défaut artificiel sur un plan d'empilement du dispositif de laser semi-conducteur à cristal photonique (100).

4. Dispositif de laser semi-conducteur à cristal photonique (100) selon la revendication 1, dans lequel les trous (H) forment une structure aléatoire utilisant une structure de cristal photonique désordonnée sur un plan d'empilement du dispositif laser semi-conducteur à cristal photonique (100).

5. Dispositif de laser semi-conducteur à cristal photonique (100) selon la revendication 1, dans lequel les trous (H) sont formés dans une région centrale du dispositif de laser semi-conducteur à cristal photonique (100), et la couche d'électrode de type n (11) est formée dans une région périphérique dans laquelle les trous (H) ne sont pas formés.

6. Dispositif de laser semi-conducteur à cristal photonique (100) selon la revendication 1, dans lequel la couche d'électrode de type p (12) est formée en contact avec une région correspondant au motif de cristal photonique dans la couche de contact de type p (23).

7. Procédé de fabrication d'un dispositif de laser semi-conducteur à cristal photonique (100), le procédé comprenant les étapes consistant à :
former successivement et empiler une couche de confinement de type n (21), une couche de guidage (30) comprenant une couche active (33), une couche de confinement de type p (22) et une couche de contact de type p (23) sur une première surface d'un premier substrat de type n (40) ;
former un motif de cristal photonique en formant des trous (H) traversant la couche de contact de type p (23), la couche de confinement de type p (22), la couche de guidage (30) comprenant la couche active (33) et la couche de confinement de type n (21) ;
former une première couche métallique (12-1) sur la couche de contact de type p (23) et une deuxième couche métallique (12-2) sur un deuxième substrat (10) ;
mettre en appui l'une contre l'autre la première couche métallique (12-1) et la deuxième couche métallique (12-2) et les lier par liaison métallique afin de former une couche d'électrode de type p (12) ; et
former une couche d'électrode de type n (11) sur au moins une partie du premier substrat (40) dans laquelle les trous (H) ne sont pas formés.

8. Procédé selon la revendication 7, dans lequel l'étape consistant à former la couche d'électrode de type n (11) comprend les étapes consistant à :
enlever une partie de l'épaisseur du premier substrat (40) après l'étape de liaison métallique ; et
former la couche d'électrode de type n (11) sur au moins une partie d'une surface du premier substrat (40) ayant une épaisseur partiellement enlevée.

9. Procédé de fabrication d'un dispositif de laser semi-conducteur à cristal photonique (100), le procédé comprenant les étapes consistant à :
former successivement et empiler une couche de confinement de type n (21), une couche de guidage (30) comprenant une couche active (33), une couche de confinement de type p (22) et une couche de contact de type p (23) sur une première surface d'un premier substrat de type n (40) ;
former un motif de cristal photonique en formant des trous (H) traversant la couche de contact de type p (23), la couche de confinement de type p (22), la couche de guidage (30) comprenant la couche active (33) et la couche de confinement de type n (21) ;
former une première couche métallique (12-1) sur la couche de contact de type p (23) et une deuxième couche métallique (12-2) sur un deuxième substrat (10) ;
mettre en appui l'une contre l'autre la première couche métallique (12-1) et la deuxième couche métallique (12-2) et les lier par liaison métallique afin de former une couche d'électrode de type p (12) ;
enlever complètement le premier substrat (40) après l'étape de liaison métallique ; et
former une couche d'électrode de type n (11) sur au moins une partie d'une surface de la couche de confinement de type n (21) exposée après enlèvement complet du premier substrat (40).

10. Procédé de fabrication d'un dispositif de laser semi-conducteur à cristal photonique (100), le procédé comprenant les étapes consistant à :
former successivement (S1) et empiler une couche de confinement de type n (21), une couche de guidage (30) comprenant une couche active, une couche de confinement de type p (22) et une couche de contact de type p (23) sur un premier substrat de type n (40) ;
former (S2) une première couche métallique (12-1) sur la couche de contact de type p (23) et une deuxième couche métallique (12-2) sur un deuxième substrat (10) ;
mettre en appui (S3) l'une contre l'autre la première couche métallique (12-1) et la deuxième couche métallique (12-2) et les lier par liaison métallique afin de former une couche d'électrode de type p (12) ;
enlever (S4) le premier substrat de type n (40) ;
former (S5) un motif de cristal photonique en formant des trous (H) traversant la couche de confinement de type n (21), la couche de guidage (30) comprenant la couche active (33) et la couche de confinement de type p (22) ; et
former (S6) une couche d'électrode de type n (11) sur au moins une partie d'une surface de la couche de confinement de type n (21) dans laquelle les trous (H) ne sont pas formés.
